# EUROPÄISCHE PATENTSCHRIFT

(11) **EP 0 848 484 B1**
(45) Veröffentlichungstag und Bekanntmachung des Hinweises auf die Patenterteilung: **02.10.2002**
(21) Anmeldenummer: 97121614.8
(22) Anmeldetag: 08.12.1997
(51) Int. Cl.: H02M 3/07

(54) **Schaltungsanordnung zur Erzeugung einer erhöhten Ausgangsspannung**
Circuit for generating a boosted output voltage
Circuit pour la génération d'une tension de sortie élevée

(30) Priorität: 12.12.1996 DE 19651768
(43) Veröffentlichungstag der Anmeldung: 17.06.1998
(73) Patentinhaber: Infineon Technologies AG, 81669 München (DE)
(72) Erfinder: Runkel, Patrick, Dipl.-Ing., 81673 München (DE)
(74) Vertreter: Reinhard - Skuhra - Weise & Partner

(56) Entgegenhaltungen:
- EP-A- 0 635 837

## Beschreibung

Die Erfindung betrifft eine Schaltungsanordnung zur Erzeugung einer erhöhten Ausgangsspannung mit einem p-Kanal-MOS-Transistor und einer Boostkapazität.

Derartige Schaltungsanordnungen, durch die eine über der anliegenden Versorgungsspannung erhöhte Ausgangsspannung erzeugt wird, finden in einer Vielzahl von Halbleiterschaltungen Anwendung, insbesondere bei Halbleiterspeichern. Eine Ein-Transistor-Speicherzelle eines Halbleiterspeichers, beispielsweise eines DRAM, umfaßt eine Speicherkapazität zur Speicherung eines Informationsbit sowie einen Transfertransistor, über den auf die Speicherzelle zugegriffen wird, indem die Speicherkapazität über den Hauptstrompfad des Transfertransistors mit einer Wortleitung verbunden wird. Um ein Informationsbit in Höhe des vollständigen Pegels der Versorgungsspannung in der Zelle zu speichern, ist erforderlich, daß das Gatepotential am Transfertransistor um dessen eigene Schwellenspannung über der Versorgungsspannung liegt. Wegen der üblicherweise kleinen Kanalbreite des Transfertransistors und dessen hoher Substrat-Source-Spannung liegt die Schwellenspannung aber relativ hoch.

Eine Schaltungsanordnung zur Erzeugung der erhöhten Spannung zur Ansteuerung eines Transfertransistors in einem Halbleiterspeicher ist in der EP-A-0 635 837 beschrieben. Die dort gezeigte Ladungspumpe enthält einen p-Kanal-MOS-Transistor, über den eine ausgangsseitige Ladekapazität mit einer Boostkapazität aufgeladen wird. Der Ladevorgang wird von einem Oszillator gesteuert und fortlaufend durchgeführt, wobei die Ausgangsspannung dauerhaft vorliegt. Es sind deshalb zusätzliche Schalter notwendig, um die erhöhte Spannung an den Transfertransistor weiterzuleiten. Während der Gateanschluß des p-Kanal-MOS-Transistors auf 0 V liegt, ist einer der Anschlüsse seines Hauptstrompfades bereits mit der am Ladekondensator anliegenden, über die Versorgungsspannung hinaus erhöhten Ausgangsspannung verbunden. Das Gateoxid des p-Kanal-Ladetransistors ist erhöhtem Spannungsstreß ausgesetzt. Darüber hinaus wechselt die zwischen den Anschlüssen des Hauptstrompfads des Lasttransistors anliegende Spannung während des Pumpvorgangs die Richtung. Es sind deshalb besondere Maßnahmen beschrieben, um Stromfluß in der Dotierungswanne, in der der Ladetransistor angeordnet ist, zu vermeiden.

Die Aufgabe der Erfindung besteht darin, eine Schaltungsanordnung der eingangs genannten Art anzugeben, bei der der p-Kanal-MOS-Ladetransistor geringerem Spannungsstreß unterliegt.

Erfindungsgemäß wird diese Aufgabe durch eine Schaltungsanordnung nach den Merkmalen des Patentanspruchs 1 gelöst.

Dadurch, daß das Gatepotential des Ladetransistors während der Ladungspumpphase schwebend gehalten wird, werden unzulässig hohe Spannungsbelastungen am Gateoxid vermieden. Die Pumpphase ist dabei diejenige Zeitdauer, während der die Ausgangsspannung über die Versorgungsspannung hinaus angehoben wird. Durch die parasitären Kapazitäten am Ladetransistor wird das Gatepotential während der Spannungserhöhung mitgeführt, so daß der Transistor leitend bleibt. Die Spannungen zwischen dem Gate und den Dotierungsgebieten für Drain und Source des Ladetransistors bleiben aber trotzdem kleiner als die Versorgungsspannung.

Vorteilhafte Weiterbildungen der Erfindung sind in den Unteransprüchen angegeben.

Durch Vorladetransistoren an beiden Anschlüssen des Hauptstrompfads des Ladetransistors sowie einem ausgangsseitigen Entladetransistor und einer entsprechenden Ablaufsteuerung wird erreicht, daß während jedes Pumpzyklusses von der Ausgangsspannung der Wertebereich von 0 V bis zum erhöhten Ausgangsspannungswert durchlaufen wird. Die Spannung an den Anschlüssen des Hauptstrompfads des Ladetransistors bleibt dabei stets gleich orientiert. Die Dotierungswanne, in der der Ladetransistor angeschlossen ist, kann deshalb ohne weiteres an einen auf Seite der Boostkapazität liegenden Spannungsknoten angeschlossen werden.

Nachfolgend wird die Erfindung anhand der in der Zeichnung dargestellten Figuren näher erläutert. Es zeigen:
- Figur 1: ein Schaltungsdiagramm einer erfindungsgemäßen Schaltungsanordnung zur Erzeugung einer erhöhten Ausgangsspannung und
- Figur 2: ein Zeitablaufdiagramm von in der Figur 1 vorkommenden Signalen.

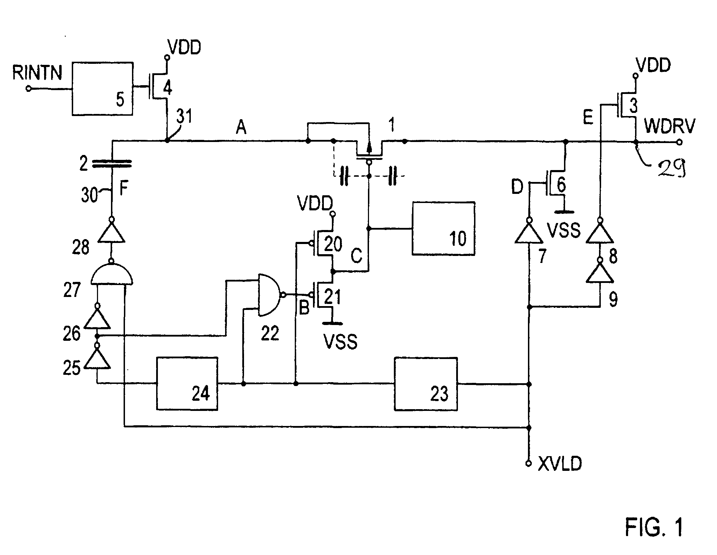

Die Schaltung der Figur 1 enthält einen p-Kanal-MOS-Transistor 1, dessen Hauptstrompfad zwischen einen Ausgangsanschluß 29 und einen Boostkondensator 2 (Knoten 31) geschaltet ist. Am Anschluß 29 liegt ein Ausgangssignal WDRV vor, das bezüglich der durch die Potentiale VDD, VSS der Versorgungsspannung eine höhere Ausgangsspannung liefert. Ein erster n-Kanal-MOS-Transistor 3 ist als Vorladetransistor zwischen den Ausgangsanschluß 29 und einen Anschluß für das positive Versorgungspotential VDD geschaltet. Ein zweiter Vorladetransistor 4 ist zwischen dem boostkondensatorseitigen Anschluß des Transistors 1 und dem Versorgungspotential VDD angeordnet. Ein n-Kanal-MOS-Transistor 6 dient als Entladetransistor und ist zwischen dem Ausgangsanschluß 29 und einem Anschluß für das Massepotential VSS angeordnet.

Während der vom Transistor 1 abgewandte Anschluß 30 des Boostkondensators 2 auf niedrigem Pegel liegt (z.B. Massepotential VSS), wird er über den Vorladetransistor 4 geladen.

In entsprechender Weise wird der Ausgangsknoten 29 über den Vorladetransistor 3 vorgeladen. Anschließend wird der Transistor 1 zum Potentialausgleich zwischen den Knoten 29, 31 leitend geschaltet. Danach wird sein Gateanschluß auf schwebendem Potential gehalten, und der Anschluß 30 der Boostkapazität 2 wird auf hohes Potential (z.B. Potential VDD) angehoben, so daß das Ausgangssignal WDRV ein um die Boostkondensatorspannung über das positive Versorgungspotential VDD erhöht liegendes Potential aufweist. Beim Abschalten wird der Knoten 29 über den nunmehr leitend geschalteten Transistor 6 entladen und auf Massepotential VSS gezogen, der Anschluß 30 der Boostkapazität wird wieder auf niedriges Potential gelegt.

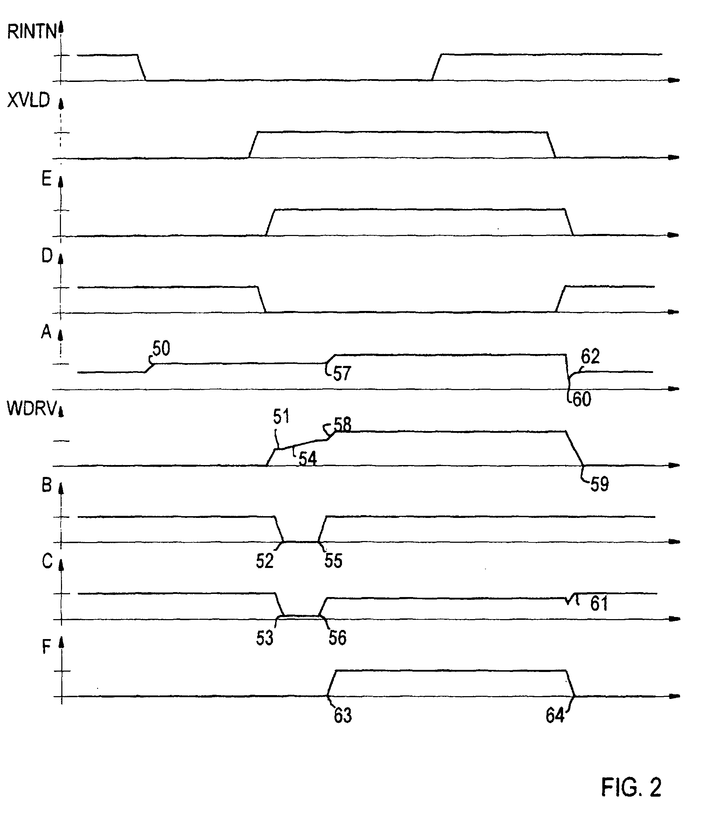

Die Funktionsweise der in Figur 1 gezeigten Schaltung wird nachfolgend detailliert anhand des in der Figur 2 dargestellten Signalverlaufdiagramms beschrieben. Anfangs wird der Knoten 31 über den Transistor 4 aus dem positiven Versorgungspotential VDD aufgeladen. Das Signal A am Knoten 31 weist dann das positive Versorgungspotential abzüglich der Schwellenspannung des n-Kanal-Transistors 5 auf (VDD - Vthn). Mit der Aktivierung des Signals RINTN, d.h. wenn das Signal RINTN von einem H- auf einen L-Pegel übergeht, wird eine Anordnung 4 aktiviert, die bereits ein über dem Versorgungspotential VDD liegendes Potential erzeugt, wodurch der Transistor 4 mit ausreichend hoher Gatespannung angesteuert wird, so daß der Knoten 31 auf das Versorgungspotential VDD vollständig angehoben wird (Stelle 50 in Figur 2). Mit Aktivierung des Signals XVLD wird der Pumpvorgang eingeleitet. In einem Halbleiterspeicher wird das Signal XVLD dann erzeugt, wenn die Zugriffsadressen für das Speicherzellenfeld stabil vorliegen. Ein Signal D am Gateanschluß des Transistors 6 wird aus dem Signal XVLD über einen Inverter 7 erzeugt. Es bewirkt, daß der Entladetransistor 6 abgeschaltet wird. Geringfügig später wird über zwei Inverter 8, 9 aus dem Signal XVLD eine Flanke eines Signals E erzeugt, das den Gateanschluß des Vorladetransistors 3 ansteuert. Dadurch wird das Potential am Ausgangsanschluß 29 auf das Versorgungspotential VDD abzüglich der Schwellenspannung des Transistors 3 angehoben (Stelle 51). Wichtig ist, daß die Transistoren 6, 3 in der eben beschriebenen Weise zeitversetzt aus- bzw. eingeschaltet werden, so daß zwischen den Versorgungsspannungsanschlüssen kein leitender Strompfad besteht.

Der Gateanschluß des Ladetransistors 1 ist mit einem zwischen die Versorgungsspannung VDD, VSS geschalteten Strompfad verbunden, der zwei mit ihren Hauptstrompfaden in Reihe geschaltete p-Kanal-MOS-Transistoren 20, 21 enthält. Er ist an den Kopplungsknoten der Transistoren 20, 21 angeschlossen. Der Gateanschluß des masseseitigen Transistors 21 wird über ein NAND-Gatter 22 angesteuert. Dessen Eingänge werden vom Signal XVLD gesteuert, wobei dieses einerseits über ein erstes Verzögerungselement 23 an das NAND-Gatter 22 angelegt wird und andererseits über ein dazu in Reihe liegendes weiteres Verzögerungsglied 24 sowie einen Inverter 25. Dies bewirkt, daß nach Ablauf der durch das Verzögerungsglied 23 bewirkten Verzögerungszeit das Signal B am Gateanschluß des Transistors 21 auf Masse gezogen wird (Stelle 52). Dadurch wird das Gatepotential des Transistors 1 auf Massepotential VSS zuzüglich der Schwellenspannung des Transistors 21 gelegt (VSS + VThp; Stelle 53). Der Transistor 1 ist somit vollständig leitend geschaltet, so daß ein Potentialausgleich zwischen den Knoten 29, 31 erfolgt (Stelle 54). Nach der durch das zweite Verzögerungsglied 24 und den Inverter 25 bewirkten Verzögerung wird über das NAND-Gatter 22 der Transistor 21 wieder abgeschaltet (Stellen 55, 56).

Der Anschluß 30 des Boostkondensators 2 ist über einen Inverter 28 mit einem weiteren NAND-Gatter 27 verbunden. Dessen Eingänge werden vom Signal XVLD sowie dem über die Verzögerungsglieder 23, 24 sowie die Inverter 25, 26 verzögerten Signal XVLD angesteuert. Dadurch wird bewirkt, daß nunmehr der Knoten 31 vom Massepotential VSS auf das positive Versorgungspotential VDD angehoben wird (Stellen 63, 57). Dadurch, daß die Transistoren 21, 20 des den Gateanschluß des Transistors 1 ansteuernden Strompfads beide gesperrt sind, verhält sich das Gatepotential des Transistors 1 schwebend. Dies bedeutet, daß das Gatepotential nicht aktiv auf einem festen Pegel gehalten wird, sondern sich entsprechend der parasitär einwirkenden Beschaltung verhält. Hierbei ist insbesondere die parasitäre Kapazität des Gates zum Kanal wirksam sowie außerdem dessen parasitäre Kapazität zu den Dotierungsgebieten von Drain und Source des Hauptstrompfads des Transistors 1. Der Kapazitätsbelag wird im wesentlichen durch die Gateoxiddicke eingestellt. Die übrige kapazitive Belastung des Gateanschlusses beispielsweise gegenüber den Drain- bzw. Sourcedotierungsgebieten der Transistoren 20, 21 ist gegenüber den oben genannten parasitären Kapazitäten wesentlich geringer. Mit dem Anstieg des Knotens 31 über das positive Versorgungspotential VDD wird das Gate des Transistors 1 kapazitiv nachgeführt, da schwebend. Der Transistor 1 bleibt deshalb genügend leitend, um das am Knoten 31 anliegende Potential an den Ausgangsknoten 29 weiterzugeben (Stelle 58). Nunmehr liegt das Ausgangssignal WDRV auf der gewünschten erhöhten Ausgangsspannung. Einem vom Signal WDRV angesteuerten Transfertransistor im Zellenfeld eines Halbleiterspeichers wird dadurch ermöglicht, die volle Betriebsspannung VDD an einen angeschlossenen Speicherkondensator weiterzugeben.

Um die Betriebssicherheit zu erhöhen, ist eine Schaltung 10 vorgesehen, durch die das Gatepotential des Transistors 1 auf das positive Versorgungspotential VDD begrenzt wird. Dies soll verhindern, daß eine parasitäre Diode zur n-Wanne des p-Kanal-MOS-Transistors 1 leitend wird. Für die Schaltung 10 werden herkömmliche Begrenzungsschaltungen vorgesehen. Eine derartige Schaltung umfaßt beispielsweise eine MOS-Diode aus einem n-Kanal-MOS-Transistor, dessen Gateanschluß zusammen mit einem Anschluß seines Hauptstrompfads an den Gateanschluß des Transistors 1 angeschlossen ist und dessen anderer Anschluß des Hauptstrompfads an ein Potential VDD - VThn angeschlossen ist.

Der Abschaltvorgang wird mit der fallenden Flanke des Signals XVLD eingeleitet. Daraufhin wird nach Verzögerung über den Inverter 7 der Transistor 6 eingeschaltet und das Signal WDRV bis auf Massepotential gezogen (Stelle 59). Außerdem wird währenddessen nach Verzögerung über die Inverter 8, 9 das Signal E von einem H- zu einem L-Pegel umgeschaltet. Dabei ist zu beachten, daß die Gate-Source-Spannung des Transistors 3 stets unterhalb seiner Schwellenspannung liegt, so daß der Transistor 3 abgeschaltet ist und kein leitender Strompfad zwischen den Versorgungsspannungsanschlüssen vorliegt. Zweckmäßigerweise ist das Signal WDRV stets größer als das Potential am Gate des Transistors 3, indem die Entladeflanke des Signals E schneller abfällt als die Flanke des Signals WDRV. Dieses Schaltverhalten der Signale D, E wird durch entsprechende Dimensionierung der Inverter 7 und 9, 8 erreicht. Mit dem Einschalten des Transistors 6 wird das Potential des Knotens 31 abgesenkt, da der Transistor 1 kurzzeitig leitet (Stelle 60). Mit der fallenden Flanke des Signal XVLD wird auch der Knoten 30 über das NAND-Gatter 27 und den Inverter 28 auf Masse gezogen, so daß das Entladen des Knotens 31 unterstützt wird (Stelle 64). Der Transistor 1 wird dann vollständig abgeschaltet, indem der mit dem Potential VDD verbundene Transistor 20 leitend geschaltet wird (Stelle 61). Der Knoten 31 wird dann wieder auf das Potential VDD - VThn gezogen (Stelle 62), so daß der Ausgangszustand vorliegt.

In der in Figur 1 gezeigten Realisierung weist der dem Knoten 31 zugewandte Anschluß des Hauptstrompfads des Transistors 1 stets höheres Potential auf als der dem Ausgangsanschluß 29 zugewandte Anschluß des Hauptstrompfads. Es ist deshalb zweckmäßig, die n-Dotierungswanne, in der der p-Kanal-MOS-Transistor 1 bei einem p-Substrat realisiert ist, an den dem Boostkondensator 2 zugewandten Leitungspfad anzuschließen, beispielsweise ein das entsprechende daran angeschlossene Dotierungsgebiet. Substrat-Wanne-Dioden sind somit stets sicher gesperrt.

Der Kapazitätswert des Boostkondensators 2 wird aufgrund kapazitiver Spannungsteilung zwischen dem Boostkondensator 2 und der am Ausgangsanschluß 29 angeschlossenen kapazitiven Belastung unter Berücksichtigung der gewünschten Höhe der Ausgangsspannung berechnet. Die beschriebene Schaltung weist einen relativ geringen Flächenverbrauch und geringe Bauelementeanzahl auf. Obwohl der gesamte Spannungsbereich von Massepotential (0 V) bis zur über dem positiven Versorgungspotential VDD liegenden erhöhten Ausgangsspannung bei jedem Pumpvorgang durchlaufen wird, entstehen weder kritische Spannungsverhältnisse noch unerwünschte Wanneneffekte. Die zwischen Gate und den Dotierungsgebieten des Ladetransistors 1 auftretenden Spannungen sind kleiner als die Versorgungsspannung VSS, VDD, so daß übermäßiger Spannungsstreß am Gateoxid des Transistors 1 vermieden wird.

## Patentansprüche

1. Schaltungsanordnung zur Erzeugung einer erhöhten Ausgangsspannung enthaltend:
- einen p-Kanal-MOS-Transistor (1) mit einem Hauptstrompfad, der mit einem Ausgangsanschluß (29) zum Abgriff der erhöhten Ausgangsspannung (WDRV) verbunden ist, und mit einem Gateanschluß,
- eine Boostkapazität (2), die an den Hauptstrompfad des p-Kanal-MOS-Transistors (1) angeschlossen ist,
- einen ersten Vorladetransistor (3), der mit dem Ausgangsanschluß (29) verbunden ist, sowie einen zweiten Vorladetransistor (4), der mit der Boostkapazität (2) verbunden ist, und
- Steuerschaltungsmittel (20, ..., 28), die bewirken, daß während einer ersten Phase (53-56) der Gateanschluß des p-Kanal-MOS-Transistors (1) auf einem niedrigen Potential gehalten wird und die Vorladetransistoren (3, 4) eingeschaltet sind, daß während einer zweiten Phase (58) der Gateanschluß des p-Kanal-MOS-Transistors (1) ein schwebendes Potential aufweist und daß ein vom Hauptstrompfad des p-Kanal-MOS-Transistors (1) abgewandter Anschluß (30) der Boostkapazität (2) während der ersten Phase ein niedriges Potential aufweist und während der zweiten Phase ein hohes Potential.

2. Schaltungsanordnung nach Anspruch 1,
**dadurch gekennzeichnet, daß**
die Steuerschaltungsmittel (20, ..., 28) einen Strompfad mit einem ersten (20) an einen Anschluß für den positiven Pol (VDD) einer Versorgungsspannung angeschlossenen und einen zweiten (21) an einen Anschluß für den negativen Pol (VSS) der Versorgungsspannung angeschlossenen Transistor enthalten, deren Kopplungsknoten mit dem Gate des p-Kanal-MOS-Transistors (1) verbunden ist, daß der zweite Transistor (21) während der ersten Phase leitend geschaltet ist, daß keiner der Transistoren (20, 21) während der zweiten Phase leitend ist und daß der erste Transister (20) außerhalb der ersten und der zweiten Phase leitend geschaltet ist.

3. Schaltungsanordnung nach einem der Ansprüche 1 oder 2,
**dadurch gekennzeichnet, daß** der zweite Vorladetransistor (4) von einer Schaltungsanordnung (5) angesteuert wird, die eine erhöhte Spannung während und eine Zeitdauer vor der ersten Phase erzeugt.

4. Schaltungsanordnung nach Anspruch 2,
**dadurch gekennzeichnet, daß** den Steuerschaltungsmitteln (20, ..., 28) ein Steuersignal (XVLD) zuführbar ist, daß das Steuersignal (XVLD) über ein erstes und ein nachgeschaltetes zweites Verzögerungsglied (23, 24) verzögerbar ist, daß durch den Ausgang des ersten Verzögerungsglieds (23) der erste Transistor (20) des Strompfads ansteuerbar ist und über ein Logikgatter (22) der zweite Transistor (21), daß durch den Ausgang des zweiten Verzögerungsglieds (24) über das Logikgatter (22) der zweite Transistor (21) ansteuerbar ist und daß durch den Ausgang des zweiten Verzögerungsglieds (24) und durch das Steuersignal (XVLD) über ein weiteres Logikgatter (27) die Boostkapazität (2) an dem vom Hauptstrompfad des p-Kanal-MOS-Transistors (1) abgewandten Anschluß (30) ansteuerbar ist.

5. Schaltungsanordnung nach einem der Ansprüche 1 bis 4,
**dadurch gekennzeichnet, daß** der Gateanschluß des p-Kanal-MOS-Transistors (1) mit Schaltungsmitteln (10) verbunden ist, durch die das Potential des Gateanschlusses auf den positiven Pol (VDD) der Versorgungsspannung begrenzbar ist.

6. Schaltungsanordnung nach einem der Ansprüche 1 bis 5,
**gekennzeichnet durch**
einen mit dem Ausgangsanschluß (29) verbundenen Entladetransistor (6), der außerhalb der ersten und zweiten Phasen leitend geschaltet ist.

7. Schaltungsanordnung nach Anspruch 6,
**dadurch gekennzeichnet, daß**
der p-Kanal-Transistor (1) in einer n-Wanne in einem p-Substrat realisiert ist und daß die Wanne an einen mit der Boostkapazität (2) gekoppelten Schaltungsknoten (31) angeschlossen ist.

## Claims

1. A circuit arrangement for generating a boosted output voltage, containing:
- a p-channel MOS transistor (1) having a main current path which is connected to an output terminal (29) for picking off the boosted output voltage (WDRV), and having a gate terminal,
- a boosting capacitor (2), which is connected to the main current path of the p-channel MOS transistor (1),
- a first precharging transistor (3), which is connected to the output terminal (29), as well as a second precharging transistor (4), which is connected to the boosting capacitor (2), and
- control circuit means (20, ..., 28), which ensure that, during a first phase (53-56), the gate terminal of the p-channel MOS transistor (1) is held at a low potential and the precharging transistors (3, 4) are turned on, that, during a second phase (58), the gate terminal of the p-channel MOS transistor (1) has a floating potential, and that a terminal (30) of the boosting capacitor (2) which is remote from the main current path of the p-channel MOS transistor (1) has a low potential during the first phase and a high potential during the second phase.

2. The circuit arrangement as claimed in claim 1,
wherein the control circuit means (20, ..., 28) contain a current path having a first transistor (20), which is connected to a terminal for the positive pole (VDD) of a supply voltage, and a second transistor (21), which is connected to a terminal for the negative pole (VSS) of the supply voltage, the coupling node of which transistors is connected to the gate of the p-channel MOS transistor (1), wherein the second transistor (21) is switched on during the first phase, wherein none of the transistors (20, 21) is switched on during the second phase, and wherein the first transistor (20) is switched on outside the first and second phases.

3. The circuit arrangement as claimed in either of claims 1 and 2,
wherein the second precharging transistor (4) is driven by a circuit arrangement (5), which generates a boosted voltage during, and a time period before, the first phase.

4. The circuit arrangement as claimed in claim 2,
wherein a control signal (XVLD) can be fed to the control circuit means (20, ..., 28), wherein the control signal (XVLD) can be delayed by means of a first and a downstream, second delay element (23, 24), wherein the first transistor (20) of the current path can be driven by the output of the first delay element (23), and the second transistor (21) via a logic gate (22), wherein the second transistor (21) can be driven by the output of the second delay element (24) via the logic gate (22), and wherein the boosting capacitor (2) can be driven, at the terminal (30) which is remote from the main current path of the p-channel MOS transistor (1), by the output of the second delay element (24) and by the control signal (XVLD) via a further logic gate (27).

5. The circuit arrangement as claimed in one of claims 1 to 4,
wherein the gate terminal of the p-channel MOS transistor (1) is connected to circuit means (10) which can limit the potential of the gate terminal to the positive pole (VDD) of the supply voltage.

6. The circuit arrangement as claimed in one of claims 1 to 5,
which comprises a discharge transistor (6), which is connected to the output terminal (29) and is switched on outside the first and second phases.

7. The circuit arrangement as claimed in claim 6,
wherein the p-channel transistor (1) is realized in an n-type well in a p-type substrate, and wherein the well is connected to a circuit node (31), which is coupled to the boosting capacitor (2).

## Revendications

1. Circuit destiné à générer une tension de sortie relevée, comprenant
- un transistor MOS à canal p (1) avec une voie de courant principal, qui est reliée à une connexion de sortie (29) pour capter la tension de sortie (WDRV) relevée, et avec une connexion de grille,
- un sur-condensateur (2), qui est raccordé à la voie de courant principal du transistor MOS à canal p (1),
- un premier transistor de pré-charge (3), qui est relié à la connexion de sortie (29), ainsi qu'un deuxième transistor de pré-charge (4) qui est relié au sur-condensateur (2), et
- des moyens de commande (20,..., 28), qui font en sorte que, pendant une première phase (53-56), la connexion de grille du transistor MOS à canal p (1) est maintenue à un faible potentiel et les transistors de pré-charge (3, 4) sont commutés, que, pendant une deuxième phase (58), la connexion de grille du transistor MOS à canal p (1) possède un potentiel flottant et qu'une connexion (30) du sur-condensateur (2), opposée à la voie de courant principal du transistor MOS à canal p (1), possède un faible potentiel pendant la première phase et un potentiel élevé pendant la deuxième phase.

2. Circuit selon la revendication 1, **caractérisé en ce que** les moyens de commande (20, ..., 28) comportent une voie de courant avec un premier transistor (20), raccordé à une connexion pour le pôle positif (VDD) d'une tension d'alimentation, et un deuxième transistor (21) raccordé à une connexion pour le pôle négatif (VSS) de la tension d'alimentation, dont les noeuds de couplage sont reliés à la grille du transistor MOS à canal p (1), **en ce que** le deuxième transistor (21) est commuté en mode conducteur pendant la première phase, **en ce qu'**aucun transistor (20, 21) est commuté en mode conducteur pendant la deuxième phase, et **en ce que** le premier transistor (20) est commuté en mode conducteur en dehors de la première et de la deuxième phase.

3. Circuit selon la revendication 1 ou 2, **caractérisé en ce que** le deuxième transistor de pré-charge (4) est activé par un circuit (5), qui génère une tension relevée pendant la première phase et pendant un intervalle de temps avant la première phase.

4. Circuit selon la revendication 2, **caractérisé en ce qu'**un signal de commande (XVLD) peut être acheminé vers les moyens de commande (20, ..., 28), **en ce que** le signal de commande (XVLD) peut être retardé par l'intermédiaire d'un premier et d'un deuxième élément de temporisation (23, 24), **en ce que** le premier transistor (20) de la voie de courant peut être activé par l'intermédiaire de la sortie du premier élément de temporisation (23) et le deuxième transistor (21) peut être activé par l'intermédiaire d'une porte logique (22), **en ce que** le deuxième transistor (21) peut être activé par la sortie du deuxième élément de temporisation (24) par l'intermédiaire de la porte logique (22) et **en ce que** le sur-condensateur (2), au niveau de la connexion (30) opposée à la voie de courant principal du transistor MOS à canal p (1), peut être activé par le signal de commande (XVLD) par l'intermédiaire d'une autre porte logique (27).

5. Circuit selon une des revendications 1 à 4, **caractérisé en ce que** la connexion de grille du transistor MOS à canal p (1) est reliée à des moyens de commutation (10), par lesquels le potentiel de la connexion de grille peut être limité au pôle positif (VDD) de la tension d'alimentation.

6. Circuit selon une des revendications 1 à 5, **caractérisé par** un transistor de décharge (6), relié à la connexion de sortie (29), lequel est commuté en mode conducteur en dehors de la première et de la deuxième phase.

7. Circuit selon la revendication 6, **caractérisé en ce que** le transistor MOS à canal p (1) est réalisé dans une cuve n dans un substrat p et **en ce que** la cuve est raccordée à un noeud de commutation (31) couplé au sur-condensateur (2).
